# FASCICULE DE BREVET EUROPEEN

(11) **EP 3 547 471 B1**
(45) Date de publication et mention de la délivrance du brevet: **01.03.2023**
(21) Numéro de dépôt: 19165734.5
(22) Date de dépôt: 28.03.2019
(51) Int. Cl.: H01S 5/183, H01S 5/187

(54) **DIODE LASER DE TYPE VCSEL À CONFINEMENT DE PORTEURS ET SON PROCÉDÉ DE FABRICATION**
LASERDIODE VOM TYP VCSEL MIT TRÄGERBEGRENZUNG, UND IHR HERSTELLUNGSVERFAHREN
VCSEL TYPE LASER DIODE WITH CARRIER CONFINEMENT AND METHOD FOR MANUFACTURING SAME

(30) Priorité: 29.03.2018 FR 1852737
(43) Date de publication de la demande: 02.10.2019
(73) Titulaire: Commissariat à l'énergie atomique et aux énergies alternatives, 75015 Paris (FR)
(72) Inventeur: OLIVIER, Nicolas, 38000 GRENOBLE (FR); JANY, Christophe, 38000 GRENOBLE (FR)
(74) Mandataire: Brevalex

(56) Documents cités:
- WO-A1-2015/121665
- WO-A2-2013/016676
- US-B1- 6 449 300

## Description

### DOMAINE TECHNIQUE

L'invention concerne le domaine des diodes laser qui sont des composants optoélectroniques à base de matériaux semi-conducteurs aptes à émettre de la lumière. Elle concerne plus particulièrement le domaine des diodes laser à cavité verticale émettant par la surface, ou VCSEL (pour l'anglais « vertical-cavity surface-emitting laser »).

### ÉTAT DE LA TECHNIQUE ANTÉRIEURE

Une diode laser de type VCSEL est constituée d'un empilement comportant, superposés au-dessus d'un substrat, une zone à puit(s) quantique(s) et deux miroirs de Bragg. Les deux miroirs de Bragg forment ensemble une cavité optique, à l'intérieur de laquelle se trouve la zone à puit(s) quantique(s). En fonctionnement, un faisceau laser émerge de la cavité optique, orienté selon un axe orthogonal au substrat.

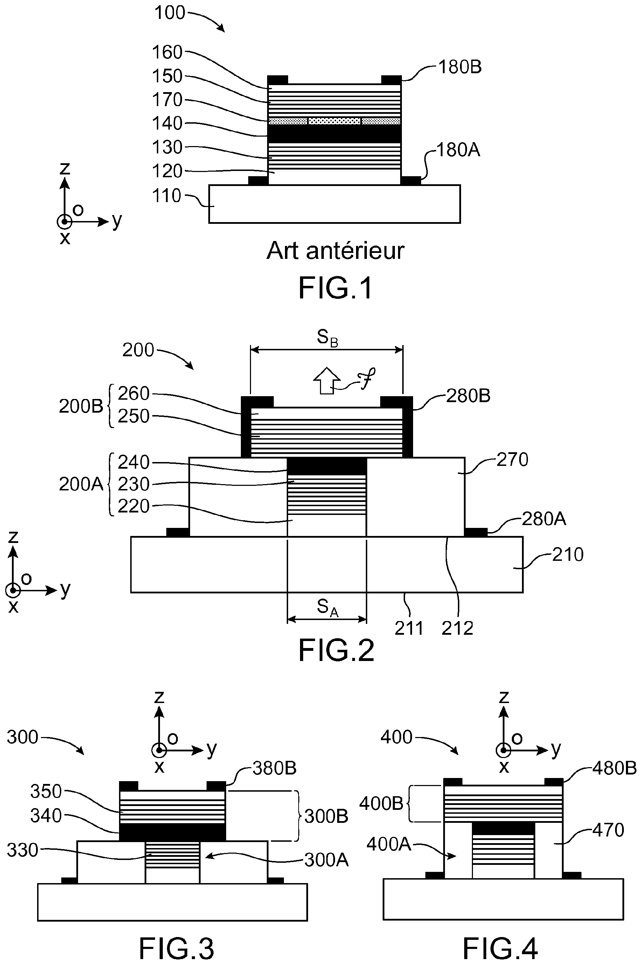

La figure 1 illustre une diode laser de type VCSEL selon l'art antérieur, en Aluminium (AI), Galium (Ga) et Arsenic(As). La diode laser 100 est représentée selon une vue en coupe dans le plan (y0z) d'un repère orthonormé (0xyz). Le plan (x0y) s'étend parallèle au plan d'un substrat 110.

La diode laser 100 comporte, superposés au-dessus du substrat 110 :
- une zone de tampon 120, présentant un premier type de dopage, N ou P ;
- un miroir de Bragg inférieur 130, hautement réfléchissant à une longueur d'onde d'émission de la diode laser 100 ;
- une zone à puit(s) quantique(s) 140, apte à émettre des photons en réponse à une excitation fournie par un courant électrique ;
- une couche de confinement 170, décrite dans la suite ;
- un miroir de Bragg supérieur 150, hautement réfléchissant à une longueur d'onde d'émission de la diode laser 100 ; et
- une zone de contact 160 présentant un second type de dopage, P ou N, de type opposé au premier type de dopage.

Sur la figure 1, on a également représenté :
- une électrode métallique supérieure 180B, située sur une face supérieure de la zone de contact 160, et ouverte au centre pour laisser passer le faisceau laser émis par la diode, en fonctionnement ; et
- une électrode métallique inférieure 180A.

Une excitation dans la zone à puit(s) quantique(s) 140 est obtenue par injection de porteurs de charge électrique, à l'aide d'un courant électrique parcourant la diode laser de haut en bas, entre l'électrode métallique supérieure 180B et l'électrode métallique inférieure 180A.

Afin d'obtenir une émission laser la plus directive possible, selon l'axe (Oz) orthogonal au plan du substrat 110, il est connu de canaliser l'injection de porteurs vers le centre de la diode laser.

Dans l'exemple illustré en figure 1, les porteurs de charge sont guidés vers le centre de la diode laser grâce à la couche de confinement 170. Il s'agit d'une fine couche à base d'AlGaAs, fortement enrichie en aluminium et oxydée latéralement. La couche de confinement 170 comporte donc une région périphérique, à forte teneur en oxyde d'aluminium, entourant une région centrale non oxydée. L'oxydation latérale est obtenue à l'aide d'un recuit dans un milieu fortement enrichi en oxygène. En fonctionnement, la région périphérique repousse les porteurs vers la région centrale, et les confine dans une région centrale de la diode laser 100.

Cette solution est décrite par exemple dans un article de M. S. Alias & al., « Optimization of Electro-Optical Characteristics of GaAs-based Oxide Confinement VCSEL », LASER PHYSICS, Vol. 20, No. 4, 2010, pp. 806-810.

Cette solution pose néanmoins des difficultés en termes de répétabilité, liées notamment à la maîtrise de l'épaisseur de la couche de confinement, à la maîtrise de sa composition en aluminium, et à la maîtrise du procédé d'oxydation latérale. Il est donc difficile de réaliser des séries de diodes laser présentant des caractéristiques électro-optiques constantes à l'échelle de la diode laser mais aussi d'une diode laser à l'autre. Ces difficultés augmentent avec la taille du substrat, lorsque l'on réalise de nombreuses diodes conjointement sur un même substrat, en déposant des couches sur de grandes surfaces et en gravant ensuite des tranchées pour isoler des diodes les unes des autres.

Une autre solution connue, pour confiner les porteurs au centre de la diode laser, consiste à réaliser une implantation ionique de protons dans une région périphérique du miroir de Bragg supérieur. Dans ce cas, la diode laser ne comporte pas la couche de confinement enrichie en aluminium, et on s'affranchit des difficultés décrites ci-dessus. En revanche, l'implantation ionique peut créer des dommages dans la maille cristalline de la diode laser nuisible à la qualité de l'émission laser. En outre, les protons implantés se répartissent, dans la diode laser, dans un volume en forme de poire. Cette solution est donc peu adaptée à des diodes laser de petites dimensions.

Un objectif de la présente invention est de proposer une solution pour confiner des porteurs de charge au centre d'une diode laser de type VCSEL, et ne présentant pas les inconvénients de l'art antérieur.

En particulier, un objectif de la présente invention est de proposer une diode laser de type VSCEL dans laquelle une solution pour confiner des porteurs de charge au centre de la diode laser peut être mise en oeuvre à l'aide d'un procédé présentant une grande répétabilité.

### EXPOSÉ DE L'INVENTION

Cet objectif est atteint avec une diode laser comportant, superposés au-dessus d'un substrat, le long d'un axe orthogonal au plan dudit substrat :
- un miroir de Bragg inférieur,
- une zone à puit(s) quantique(s), et
- un miroir de Bragg supérieur,
avec le miroir de Bragg inférieur situé entre le substrat et la zone à puit(s) quantique(s).

La diode laser selon l'invention est donc une diode laser de type VCSEL.

Selon l'invention, une section du miroir de Bragg inférieur présente une aire inférieure à celle d'une section du miroir de Bragg supérieur, lesdites sections étant définies dans des plans parallèles au plan du substrat.

En fonctionnement, le confinement des porteurs de charge au centre de la diode laser est réalisé, par construction, grâce à la section réduite du miroir de Bragg inférieur. En d'autres termes, l'invention propose un confinement spatial des porteurs de charge, à l'aide d'une géométrie particulière de la diode laser.

Comme dans l'art antérieur, le confinement permet d'obtenir une émission laser de grande directivité, orientée selon un axe orthogonal au plan du substrat. La solution de confinement proposée par l'invention n'implique ni implantation ionique, ni oxydation latérale d'une couche de confinement. Le confinement est obtenu par un dimensionnement adéquat du miroir de Bragg inférieur relativement au miroir de Bragg supérieur. Cette solution de confinement peut être mise en oeuvre par simple gravure de couches aux dimensions voulues, c'est-à-dire par un procédé présentant une grande répétabilité. Cette grande répétabilité permet notamment d'homogénéiser les performances optiques, notamment en termes d'ouverture optique, de diodes laser réalisées ensemble sur un même substrat.

L'invention permet également de relâcher des contraintes sur l'épitaxie des couches formant la diode laser, en augmentant les tolérances sur l'épaisseur et la composition de chaque couche, en comparaison avec l'art antérieur comportant une couche de confinement oxydée latéralement. Elle permet notamment de s'affranchir des contraintes sur l'épitaxie d'une couche de confinement enrichie en aluminium.

Dans les solutions de confinement par implantation ionique ou oxydation latérale d'une couche de confinement, une miniaturisation de la diode laser est limitée par un volume minimal occupé par l'implantation ionique ou par le matériau oxydé. La solution proposée par l'invention s'affranchit de ces limitations, et donne ainsi accès à des diodes laser de plus petites dimensions que dans l'art antérieur. Les diodes laser selon l'invention peuvent notamment être réparties en matrice, réparties selon un pas de répartition réduit, inférieur ou égal à 5 µm.

Le confinement de porteurs est mis en oeuvre grâce aux dimensions du miroir de Bragg inférieur. Le miroir de Bragg supérieur peut en revanche présenter une section large, facilitant la réalisation d'une électrode supérieure de la diode laser, du côté de la zone à puit(s) quantique(s) opposé au substrat.

De préférence, le faisceau laser émis en fonctionnement par la diode laser émerge de celle-ci en traversant le miroir de Bragg supérieur. Pour cela, le miroir de Bragg inférieur présente une réflectivité supérieure à celle du miroir de Bragg inférieur, à une longueur d'onde d'émission de la diode laser. Une électrode supérieure de la diode laser est donc avantageusement ouverte au centre, pour laisser passer le faisceau laser. La réalisation d'une électrode supérieure ouverte au centre est facilitée par la plus grande section du miroir de Bragg supérieur, supérieure à celle du miroir de Bragg inférieur.

La diode laser selon l'invention comprend avantageusement :
- un premier empilement, cylindrique, comprenant au moins le miroir de Bragg inférieur, et présentant une première section dans un plan parallèle au plan du substrat ; et
- un second empilement, cylindrique, comprenant au moins le miroir de Bragg supérieur, et présentant une seconde section dans un plan parallèle au plan du substrat ;
avec la zone à puit(s) quantique(s) qui appartient au premier ou au second empilement, et l'aire de la première section inférieure à l'aire de la seconde section.

Le terme « cylindrique » se rapporte ici à un cylindre droit, de génératrice orthogonale au plan du substrat, mais pas forcément un cylindre de révolution.

Selon l'invention, la diode laser selon l'invention comprend une région dite périphérique, située entre le substrat et le miroir de Bragg supérieur, et entourant le miroir de Bragg inférieur au moins. La région périphérique s'étend en particulier entre le substrat et le second empilement tel que défini ci-dessus, en entourant le premier empilement. On peut nommer « matériau de confinement » le (ou les) matériau(x) constituant la région périphérique, cette dernière réalisant un confinement des porteurs de charge dans le miroir de Bragg inférieur.

Ladite région périphérique est constituée d'au moins un matériau électriquement isolant ou semi-conducteur non dopé, en contact physique direct avec les parois latérales du miroir de Bragg inférieur. En variante, ne faisant pas partie de l'invention revendiquée, ladite région périphérique peut être constituée d'au moins matériau électriquement conducteur, avec un fourreau en matériau électriquement isolant pour la séparer des parois latérales du miroir de Bragg inférieur. En tout état de cause, les parois latérales du miroir de Bragg inférieur se trouvent en contact physique direct avec un matériau empêchant une fuite latérale des porteurs de charges.

L'invention couvre également un procédé de fabrication d'une diode laser selon l'invention, le procédé comprenant :
- une première étape de gravure, dans laquelle on grave une première série de couches comprenant, au moins, un premier ensemble de couches élémentaires optiquement réfléchissant, de manière à former un premier empilement comprenant au moins le miroir de Bragg inférieur ;
- une seconde étape de gravure, dans laquelle on grave une seconde série de couches comprenant, au moins, un second ensemble de couches élémentaires optiquement réfléchissant, de manière à former un second empilement comprenant au moins le miroir de Bragg supérieur ; et
- une étape d'encapsulation latérale du premier empilement, mise en oeuvre après la première étape de gravure ;
une section du premier empilement présentant une aire inférieure à celle d'une section du second empilement, et la deuxième étape de gravure étant mise en oeuvre après la première étape de gravure.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- la figure 1 illustre de manière schématique une diode laser de type VCSEL selon l'art antérieur, dans une vue en coupe ;
- la figure 2 illustre de manière schématique un premier mode de réalisation d'une diode laser de type VCSEL selon l'invention, dans une vue en coupe ;
- les figures 3 et 4 illustrent respectivement un deuxième et un troisième modes de réalisation d'une diode laser de type VCSEL selon l'invention, dans une vue en coupe ;
- la figure 5 illustre de manière schématique un premier mode de réalisation d'un procédé de fabrication selon l'invention ; et
- les figures 6 et 7 illustrent respectivement un deuxième et un troisième modes de réalisation d'un procédé selon l'invention.

### EXPOSÉ DÉTAILLÉ DE MODES DE RÉALISATION PARTICULIERS

La figure 2 illustre un premier mode de réalisation d'une diode laser 200 selon l'invention. La diode laser 200 est représentée selon une vue en coupe dans le plan (y0z) d'un repère orthonormé (0xyz).

Un substrat 210, également nommé substrat hôte, présente une forme de parallélépipède rectangle avec une face inférieure 211 et une face supérieure 212 qui s'étendent chacune selon un plan parallèle au plan (x0y). On définit le plan du substrat comme un plan parallèle à ce plan (x0y). Le substrat 210 est par exemple en arséniure de gallium (GaAs).

La diode laser 200 comprend, superposés dans cet ordre au-dessus du substrat 210, le long d'un axe (0z) orthogonal au plan du substrat :
- une zone de tampon 220 (optionnelle), constituée ici d'une fine couche de GaAs dopé, avec un premier type de dopage, N ou P ;
- un miroir de Bragg inférieur 230, hautement réfléchissant à une longueur d'onde d'émission de la diode laser 200, constitué ici d'une alternance de couches d'arséniure de gallium (GaAs) et de couches d'arséniure de gallium-aluminium (AIGaAs) ;
- une zone à puit(s) quantique(s) 240, constituée ici d'au moins un puit quantique formé par un empilement d'au moins une couche d'arséniure de gallium (GaAs) et au moins une couche d'arséniure d'indium ou d'arséniure d'indium-gallium (In(Ga)As);
- un miroir de Bragg supérieur 250, hautement réfléchissant à une longueur d'onde d'émission de la diode laser 200, constitué également d'une alternance de couches de GaAs et de couches d'AlGaAs ; et
- une zone de contact 260 (optionnelle), constituée ici d'une fine couche d'arséniure de gallium (GaAs) dopé, avec un second type de dopage, P ou N, de type opposé au premier type de dopage.

La diode laser 200 ne comporte pas de région enrichie localement en protons par implantation ionique, ni de couche de confinement oxydée latéralement.

Un puits quantique désigne en particulier une hétérostructure en matériau semi-conducteur. La dimension de l'hétérostructure dans une des directions de l'espace est de quelques dizaines de nanomètres. La zone à puit(s) quantique(s) 240, ou zone active, permet la génération de photons sous l'effet d'une excitation électrique, à une longueur d'onde située entre 600 nm et 1300 nm (selon la composition, l'épaisseur et la quantité des puits quantiques). En fonctionnement, les photons générés dans la zone à puit(s) quantique(s) 240 sont réfléchis par les miroirs de Bragg inférieur et supérieur, jusqu'à obtention de l'effet laser. L'émission de lumière se fait selon un axe orthogonal au plan du substrat 210.

Le miroir de Bragg inférieur 230 présente une réflectivité supérieure celle du miroir de Bragg supérieur 250, à la longueur d'onde d'émission de la zone à puit(s) quantique(s) 240. Par exemple, un taux de réflexion du miroir de Bragg inférieur 230 est supérieur à 99%, et un taux de réflexion du miroir de Bragg supérieur 250 est compris entre 90% et 98%, à une longueur d'onde d'émission de la zone à puit(s) quantique(s) 240. En fonctionnement, un faisceau laser 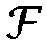 émerge de la diode laser 200, du côté de la zone à puit(s) quantique(s) 240 opposé au substrat, en traversant le miroir de Bragg supérieur 250. La réflectivité de chacun des miroirs de Bragg est fonction du nombre de bicouches AIGaAs/GaAs. Ainsi, le miroir inférieur aura un nombre de bicouches important (haute réflectivité) et le miroir supérieur en aura moins (basse réflectivité), afin que les photons puissent sortir par le haut.

Les éléments de la diode laser 200 listés ci-dessus sont répartis dans deux empilements élémentaires superposés :
- un premier empilement, 200A, comprenant ici la zone de tampon 220, le miroir de Bragg inférieur 230 et la zone à puit(s) quantique(s) 240 ; et
- un second empilement, 200B, comprenant ici le miroir de Bragg supérieur 250 et la zone de contact 260.

Le premier empilement, 200A, présente une forme de cylindre droit, de génératrice parallèle à (0z) et de section *S_{A}* parallèle au plan (x0y). La section *S_{A}* présente une largeur comprise de préférence, mais de manière non limitative, entre 6 µm et 8 µm. Il s'agit par exemple, mais de manière non limitative, d'un disque de diamètre compris entre 6 µm et 8 µm ou d'un carré de côté compris entre 6 µm et 8 µm.

Le second empilement, 200B, présente une forme de cylindre droit, de génératrice parallèle à (0z) et de section *S_{B}* parallèle au plan (x0y).

Selon l'invention, l'aire de la section *S_{A}* est inférieure à l'aire de la section *S_{B}.* La différence entre l'aire de la section *S_{B}* et l'aire de la section *S_{A}* est par exemple supérieure ou égale à 10%, 25% et voire même 40% de l'aire de la section *S_{B}.*

Dans un cas particulier, les sections *S_{A}* et *S_{B}* présentent chacune une forme de disque de diamètres différents. Dans un autre cas particulier, les sections *S_{A}* et *S_{B}* présentent chacune une forme de carré présentant chacun un côté de valeur différente.

Un axe central du premier empilement 200A, parallèle à (0z), est confondu avec un axe central du second empilement 200B, parallèle à (0z). Les premier et second empilements 200A, 200B, forment ensemble une structure présentant une section en forme de T dans un plan parallèle à l'axe (0z).

Le miroir de Bragg inférieur 230, appartenant au premier empilement 200A, présente donc une section inférieure à celle du miroir de Bragg supérieur 250, appartenant au second empilement 200B. En fonctionnement, des porteurs de charge sont confinés au centre de la diode laser 200, grâce à la section réduite du miroir de Bragg inférieur 230.

Ici, la diode laser 200 comprend également une région dite périphérique 270, qui s'étend entre le substrat 210 et le second empilement 200B, en entourant le premier empilement 200A. Elle présente une forme de cylindre droit, de génératrice parallèle à (0z), et de section ouverte au centre pour laisser passer le premier empilement 200A. Ici, la région périphérique 270 dépasse latéralement relativement au second empilement 200B, dans des plans parallèles au plan (x0y).

La région périphérique 270 est constituée d'un matériau solide tel qu'un diélectrique (par exemple SiN, SiO₂, SiOx, ou une combinaison de ces matériaux), un polymère (par exemple du benzocyclobutène), un semi-conducteur non dopé (par exemple un semi-conducteur dit III-V composé d'un ou plusieurs éléments de la colonne III et de la colonne V du tableau périodique de Mendeleïev), ou même un oxyde métallique (Al₂O₃ par exemple). Elle est constituée en particulier d'au moins un matériau parmi les matériaux listés ci-dessus. Elle est formée par exemple d'un empilement de couches formées chacune de l'un des matériaux listés ci-dessus.

En variante, ne faisant pas partie de l'invention revendiquée, la région périphérique 270 est en matériau électriquement isolant et selon l'invention, la région périphérique 270 est en matériau semi-conducteur non dopé, et s'étend en contact physique direct avec les parois latérales du premier empilement 200A.

En variante, ne faisant pas partie de l'invention revendiquée, la région périphérique 270 est en matériau électriquement conducteur (oxyde métallique), et elle est séparée des parois latérales du premier empilement 200A par un fourreau en matériau électriquement isolant (par exemple un diélectrique tel que du SiN, du SiO₂, du SiOx, ou une combinaison de ces matériaux; un polymère; ou du benzocyclobutène).

En tout état de cause, les parois latérales du miroir de Bragg inférieur se trouvent en contact physique direct avec un matériau empêchant une fuite latérale des porteurs de charges.

La diode laser selon l'invention présente ainsi une architecture de type « *Semi Insulating Buried Heterostructure* », c'est-à-dire à hétérostructure semi-conductrice ensevelie, ensevelie ici dans la région périphérique 270.

Sur la figure 2, on a également représenté :
- une électrode métallique supérieure 280B de la diode laser, ouverte au centre pour laisser passer le faisceau laser 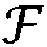 ; et
- une électrode métallique inférieure 280A.

L'électrode métallique inférieure 280A s'étend ici sur le substrat 210, en entourant la région périphérique 270.

Selon que le substrat 210 est électriquement conducteur ou électriquement isolant, l'électrode métallique inférieure 280A peut s'étendre :
- du côté du substrat 210 opposé au premier empilement 200A ;
- du même côté du substrat 210 que le premier empilement 200A, en entourant partiellement ou entièrement la région périphérique 270 ; ou
- du même côté que le substrat 210, et en s'étendant jusque sous le premier empilement 200A.

L'électrode métallique supérieure 280B s'étend ici à la fois sur une face supérieure du second empilement 200B, du côté opposé au substrat 210, et sur les parois latérales dudit second empilement 200B.

De préférence, au moins la moitié de la surface totale de l'électrode métallique supérieure 280B s'étend sur les parois latérales du second empilement 200B. Le cas échéant, l'électrode métallique supérieure 280B peut s'étendre entièrement sur les parois latérales du second empilement 200B.

Cette disposition de l'électrode métallique supérieure 280B, au moins en partie sur les parois latérales du second empilement 200B, présente de nombreux avantages :
- le miroir de Bragg supérieur est protégé latéralement ;
- la surface totale de l'électrode métallique supérieure est augmentée, ce qui améliore l'injection d'un courant d'excitation dans la diode laser ;
- on peut réduire une section minimale du second empilement 200B, et donc réduire les dimensions latérales de la diode laser ;
- on peut relâcher des contraintes en dimensionnement, et en positionnement de l'électrode métallique supérieure, tout en garantissant un passage suffisant pour laisser passer le faisceau laser émis par la diode laser.

La réalisation de l'électrode métallique supérieure 280B au moins en partie sur les parois latérales du second empilement 200B est facilitée ici par le fait que la région périphérique 270 dépasse latéralement relativement au premier empilement 200A. La région périphérique 270 forme ainsi une bordure pour délimiter l'étendue de l'électrode métallique supérieure 280B, et faire en sorte qu'elle ne dépasse pas jusqu'au niveau de la zone à puit(s) quantique(s).

Dans le mode de réalisation de la figure 2, l'électrode métallique supérieure 280B s'étend sur la totalité des parois latérales du second empilement 200B. En variante, elle peut s'étendre sur une partie seulement de celles-ci, par exemple sur au moins 20% de leur surface.

Selon une autre variante, non représentée, l'électrode métallique supérieure s'étend uniquement sur une face supérieure du second empilement 200B. Cette variante est adaptée plus particulièrement à une diode laser de grandes dimensions.

Selon l'invention, le miroir de Bragg inférieur 230 définit la plus petite ouverture de guidage pour les porteurs de charge dans la diode laser. En d'autres termes, le miroir de Bragg inférieur 30 réalise à lui seul le confinement des porteurs de charge dans la diode laser. Cette plus petite ouverture se trouve du côté de la zone à puit(s) quantique(s) opposé à une surface d'émission de la diode laser.

En outre, le miroir de Bragg inférieur 230 définit la plus petite ouverture de guidage pour le mode optique dans la diode laser. Le miroir de Bragg inférieur 30 réalise ainsi à lui seul le confinement des porteurs de charge et le confinement de mode optique dans la diode laser.

De préférence, la diode laser est dépourvue de toute couche de guidage distincte du miroir de Bragg inférieur, réalisant un confinement latéral des porteurs de charge et/ou du mode optique.

La figure 3 illustre un deuxième mode de réalisation d'une diode laser 300, qui n'est décrit que pour ses différences relativement au mode de réalisation de la figure 2.

Ici, la zone à puit(s) quantique(s) 340 appartient au second empilement 300B, et non au premier empilement 300A. En d'autres termes, la zone à puit(s) quantique(s) 340 présente la même section que le miroir de Bragg supérieur 350, et non la même section que le miroir de Bragg inférieur 330.

Dans ce mode de réalisation, mais de manière non limitative, l'électrode métallique supérieure 380B s'étend uniquement sur une face supérieure du second empilement 300B.

La figure 4 illustre un troisième mode de réalisation d'une diode laser 400, qui n'est décrit que pour ses différences relativement au mode de réalisation de la figure 2

Ici, la région périphérique 470 ne dépasse pas latéralement relativement au second empilement 400B. La région périphérique 470 et le premier empilement 400A forment ensemble un cylindre droit inférieur, de même section que celle d'un cylindre droit supérieur définissant la forme du second empilement 400B. La génératrice du cylindre droit supérieur est confondue avec celle du cylindre droit inférieur.

Dans ce mode de réalisation, mais de manière non limitative, l'électrode métallique supérieure 480B s'étend uniquement sur une face supérieure du second empilement 400B.

On décrit dans la suite des exemples de procédés pour fabriquer une diode laser selon l'invention. A titre d'illustration, mais de manière non limitative, on a illustré le cas de la fabrication d'une diode laser telle qu'illustrée en figure 2.

Chacun de ces modes de réalisation ont comme point commun de comprendre :
- une première étape de gravure, dans laquelle on grave une première série de couches comprenant, au moins, un premier ensemble de couches élémentaires, optiquement réfléchissant, de manière à former le premier empilement comprenant au moins le miroir de Bragg inférieur ; et
- une seconde étape de gravure, dans laquelle on grave une seconde série de couches comprenant, au moins, un second ensemble de couches élémentaires, optiquement réfléchissant, de manière à former le second empilement comprenant au moins le miroir de Bragg supérieur.

Un ensemble de couches élémentaires dit à puit(s) quantique(s) est gravé lors de la première ou de la seconde étape de gravure, pour former la zone à puit(s) quantique(s).

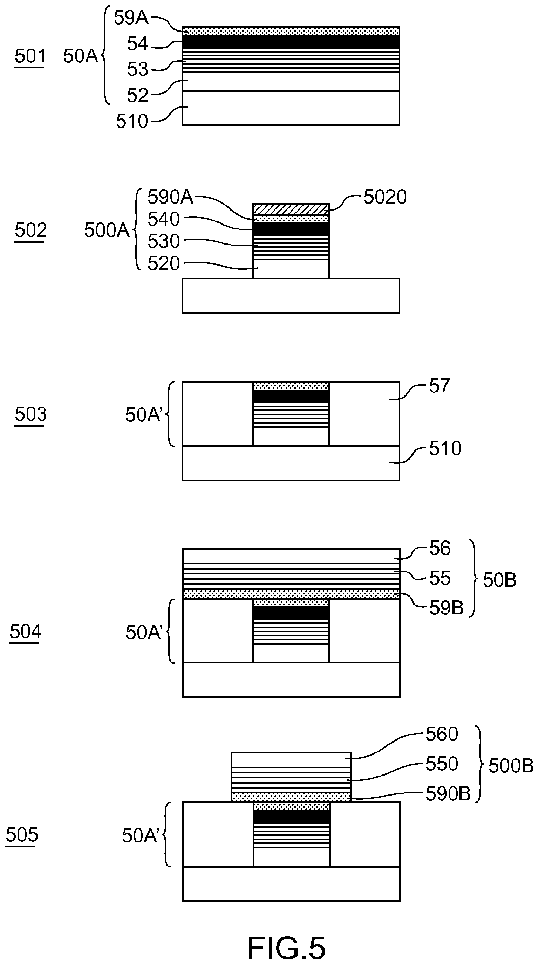

Le procédé de la figure 5 comprend les étapes suivantes, mises en oeuvre dans cet ordre :

### Etape 501 :

Première épitaxie sur un premier substrat 510, pour former une première série de couches 50A comprenant :
- une couche de tampon 52, de même nature que la zone de tampon décrite en référence à la figure 2 ;
- un premier ensemble 53 de couches élémentaires, optiquement réfléchissant, de même nature que le miroir de Bragg inférieur décrit en référence à la figure 2 ;
- un ensemble 54 de couches élémentaires dit à puit(s) quantique(s), de même nature que la zone à puit(s) quantique(s) décrite en référence à la figure 2 ; et
- une première couche d'attente 59A, constituée ici d'une fine couche de GaAs dopée (ici un dopage de type opposé à celui de la couche de tampon 52), située du côté opposé au premier substrat 510.

Le premier substrat 510 correspond ici au substrat décrit en référence à la figure 2, nommé également substrat hôte.

### Etape 502 :

Première gravure, au cours de laquelle on grave la première série de couches 50A sur toute son épaisseur, jusqu'au premier substrat 510, de manière à former un premier empilement 500A. Le premier empilement 500A comprend la zone de tampon 520, le miroir de Bragg inférieur 530, et la zone à puit(s) quantique(s) 540 d'une diode laser selon l'invention, ainsi qu'une première zone d'attente 590 formée dans la première couche d'attente 59A.

La première gravure est par exemple une gravure assistée par plasma de type gravure par ions réactifs (RIE pour « *Reactive-Ion Etching* »), ou gravure par plasma couplé par induction (ICP pour « *Inductively Coupled Plasma* »), ou RIE/ICP. En variante, la gravure est de type gravure ionique à faisceau d'ions (IBE pour « *Ion Beam Etching* », ou CAIBE pour « *Chemically Assisted Ion Beam Etching* », ou RIBE pour «*Reactive Ion Beam Etching* »). La première gravure utilise un premier masque 5020, pour protéger les zones à ne pas graver. Le premier masque 5020 peut être un diélectrique (SiN, SiOx, etc) ou un métal, ou une résine photosensible, etc.

### Etape 503 :

Reprise d'épitaxie sur le premier substrat 510 et autour du premier empilement 500A, pour faire croître une couche d'encapsulation latérale 57 de même nature que la région périphérique décrite en référence à la figure 2. La couche d'encapsulation latérale 57 est constituée d'un semiconducteur non dopé, notamment un matériau III-V d'accord de maille compatible avec le substrat 510.

La reprise d'épitaxie est suivie ensuite d'un retrait du premier masque 5020, par gravure sèche ou gravure humide.

L'étape 503 forme une étape dite d'encapsulation latérale du premier empilement 500A. Elle a pour objectif de planariser la topographie d'une structure recouvrant le premier substrat 510. Une face supérieure du premier empilement 500A, du côté opposé au premier substrat 510, reste libre, non recouverte par le matériau de la couche d'encapsulation latérale 57.

A l'issue de l'étape 503, le premier substrat 510 est recouvert par une première structure 50A', plane, comprenant le premier empilement 500A et la couche d'encapsulation latérale 57.

### Etape 504 :

Nouvelle épitaxie, pour former, sur la première structure, 50A', une seconde série de couches 50B comprenant ici :
- une seconde couche d'attente 59B, constituée ici d'une fine couche de GaAs dopée (de même type de dopage que la première couche d'attente 59A) ;
- un second ensemble 55 de couches élémentaires, optiquement réfléchissant, de même nature que le miroir de Bragg supérieur décrit en référence à la figure 2 ; et
- une couche de contact 56, de même nature que la zone de contact décrite en référence à la figure 2, en contact physique direct avec la première zone d'attente 590.

### Etape 505 :

Seconde gravure, au cours de laquelle on grave la seconde série de couches 50B sur toute son épaisseur, jusqu'à la première structure 50A', de manière à former un second empilement 500B comprenant ici une seconde zone d'attente 590B formée dans la seconde couche d'attente 59B, le miroir de Bragg supérieur 550 et la zone de contact 560.

La seconde gravure peut mettre en oeuvre les mêmes techniques de gravure que la première gravure. Elle peut être réalisée sous vide, en utilisant des gaz chlorés de type BCl₃, Cl₂, SiCl₄ ou des mélanges gazeux carbonés de type CH₄/H₂. L'adjonction d'un gaz neutre peut améliorer la gravure (Ar, N₂, etc.). On peut également utiliser une gravure chimique par exemple au bromure d'hydrogène. La seconde gravure utilise un second masque, non représenté, pour protéger les zones à ne pas graver. Le second masque peut être un diélectrique (SiN, SiOx, etc.) ou un métal, ou un matériau photosensible.

Après la seconde gravure, ou conjointement, on grave des tranchées dans la couche d'encapsulation latérale 57 pour délimiter la région périphérique de la diode, dans la couche d'encapsulation latérale 57. Cette gravure peut être une gravure par plasma RIE et/ou ICP utilisant des gaz fluorés (CHF₃, SF₃, CF₄, etc.) seuls ou en mélange avec des gaz inertes, une gravure par plasma d'ions (IBE, RIBE, CAIBE), etc. Elle utilise un masque de gravure que l'on peut retirer, ou conserver après l'avoir gravé au centre.

On réalise ensuite des électrodes supérieure et inférieure telles qu'illustrées aux figures 2 à 4. Le matériau des électrodes est déposé par dépôt physique en phase vapeur (ou PVD pour « *physical vapor déposition* »). La géométrie de chaque électrode peut être définie par gravure (lift off, ou gravure par faisceau d'électrons par exemple). L'électrode supérieure peut s'étendre en totalité ou en partie sur des parois latérales du second empilement, comme détaillé en référence à la figure 2.

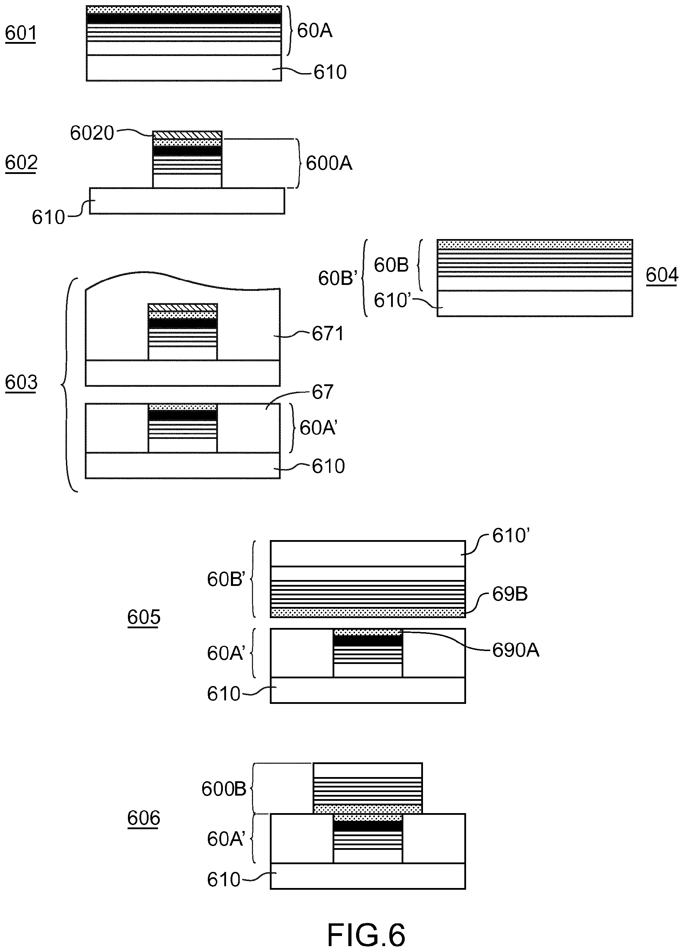

La figure 6 illustre un deuxième mode de réalisation, qui comprend les étapes suivantes, mises en oeuvre dans cet ordre :

### Etape 601 :

Première épitaxie, pour former une première série de couches 60A sur un premier substrat 610 comme décrit en référence à la figure 5 à propos de l'étape 501. Le premier substrat 610 correspond ici au substrat décrit en référence à la figure 2, nommé également substrat hôte.

### Etape 602 :

Première gravure, identique à la gravure 502 de la figure 5, au cours de laquelle on grave la première série de couches 60A sur toute son épaisseur, jusqu'au premier substrat 610, de manière à former un premier empilement 600A. La première gravure utilise un premier masque 6020, pour protéger les zones à ne pas graver.

### Etape 603 :

Encapsulation latérale du premier empilement 600A comprenant le miroir de Bragg inférieur 630. A l'issue de l'étape 603, le premier substrat 610 est recouvert par une première structure 60A', plane, telle que décrite en référence à la figure 5 à propos de l'étape 503.

Ici, l'encapsulation latérale est mise en oeuvre par dépôt d'une couche d'encapsulation 671 au-dessus du premier substrat 610 et planarisation.

La couche d'encapsulation 671 entoure et recouvre l'ensemble formé par le premier empilement 600A et le premier masque 6020. Elle est constituée par exemple d'un matériau diélectrique (SiN, SiO₂, SiOx, combinaison de ces matériaux, etc.) ou un matériau polymère (benzocyclobutène par exemple), ou un oxyde métallique (Al₂O₃ par exemple). Lorsque la couche d'encapsulation 671 est en oxyde métallique, on réalise un fourreau en matériau électriquement isolant, tel que décrit en référence à la figure 2, avant dépôt de la couche d'encapsulation 671.

La planarisation est mise en oeuvre par polissage mécano-chimique. Elle permet également de supprimer le premier masque de gravure 6020. A l'issue de la planarisation, ce qui subsiste de la couche d'encapsulation 671 forme une couche nommée couche d'encapsulation latérale 67.

### Etape 604 :

Seconde épitaxie, sur un second substrat 610', pour former une seconde série de couches 60B telle que décrite en référence à la figure 5 à propos de l'étape 504. Le second substrat 610' et la seconde série de couches 60B forment ensemble une seconde structure 60B'.

L'étape 604 peut être mise en oeuvre tout ou partie en parallèle des étapes 601 à 603, ce qui permet d'augmenter une vitesse de fabrication d'une diode laser selon l'invention.

### Etape 605 :

Report de la seconde structure 60B' sur la première structure 60A', par collage direct. Lors du collage, une première zone d'attente 690A de la première structure, située du côté opposé au premier substrat 610, et une seconde couche d'attente 69B de la seconde structure, située du côté opposé au second substrat 610', se trouvent en contact physique direct l'une avec l'autre.

Le second substrat 610' est ensuite retiré, par exemple par gravure chimique, polissage mécanique, polissage mécano-chimique, et/ou gravure lift off épitaxiale.

### Etape 606 :

Seconde gravure, au cours de laquelle on grave la seconde série de couches 60B sur toute son épaisseur, jusqu'à la première structure 60A', de manière à former un second empilement 600B, comme décrit en référence à l'étape 505 de la figure 5. Cette seconde gravure est mise en oeuvre après retrait du second substrat 610'.

Comme détaillé en référence à la figure 5, une étape de gravure de tranchées dans la couche d'encapsulation latérale 67 est mise en oeuvre conjointement ou postérieurement à la seconde gravure.

Ici, la gravure de tranchées peut être une gravure par plasma RIE et/ou ICP telle que décrite ci-avant, ou une gravure humide ou sèche (gravure d'un diélectrique par gravure humide à l'acide fluorhydrique ou à l'aide d'une solution d'oxyde gravant tamponné, gravure d'un polymère par gravure humide au trichloréthylène, gravure d'un métal par gravure sèche ou humide).

On réalise ensuite des électrodes supérieure et inférieure, comme détaillé ci-dessus.

Les procédés des figures 5 et 6 peuvent être combinés. Par exemple, dans le procédé de la figure 5, l'étape 504 peut être remplacée par les étapes 604 et 605 du procédé de la figure 6.

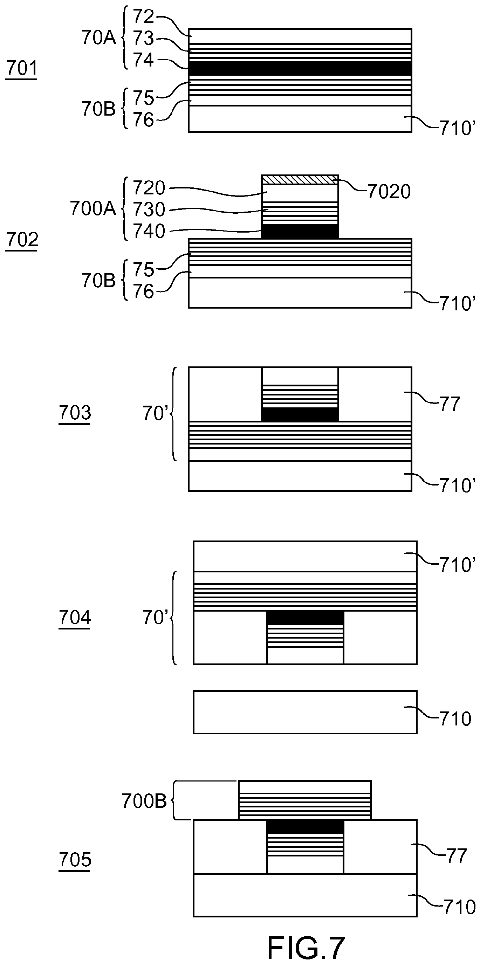

Dans les procédés des figures 5 et 6, la diode laser est formée par deux épitaxies distinctes, chacune portant une ou plusieurs fonctions électriques et/ou optiques. Une troisième épitaxie peut être mise en oeuvre pour réaliser l'encapsulation latérale du premier empilement. La figure 7 illustre un troisième mode de réalisation, mettant en oeuvre une unique épitaxie. Ce procédé comprend les étapes suivantes, mises en oeuvre dans cet ordre :

### Etape 701 :

Epitaxie, sur un premier substrat 710', d'un empilement de couches comprenant ici, dans cet ordre à partir du premier substrat 710' :
- une couche de contact 76, de même nature que la zone de contact décrite en référence à la figure 2,
- un second ensemble 75 de couches élémentaires, optiquement réfléchissant, de même nature que le miroir de Bragg supérieur décrit en référence à la figure 2 ; et
- un ensemble 74 de couches élémentaires dit à puit(s) quantique(s) 74, de même nature que la zone à puit(s) quantique(s) décrite en référence à la figure 2 ;
- un second ensemble 73 de couches élémentaires, optiquement réfléchissant, de même nature que le miroir de Bragg inférieur décrit en référence à la figure 2 ; et
- une couche de tampon 72, de même nature que la zone de tampon décrite en référence à la figure 2.

Le premier substrat 710' correspond à un substrat intermédiaire, distinct du substrat sur lequel reposera la diode *in fine.*

### Etape 702 :

Première gravure, au cours de laquelle on grave l'empilement sur une partie seulement de son épaisseur. Ici, on grave une première série de couches 70A constituée de l'ensemble 74 à puit(s) quantique(s) 74, du premier ensemble 73 de couches élémentaires, et de la couche de tampon 72. On forme ainsi un premier empilement 700A comprenant ici la zone de tampon 720, le miroir de Bragg inférieur 730 et la zone à puit(s) quantique(s) 740 d'une diode laser selon l'invention. Le premier empilement 700A s'étend ici sur une seconde série de couches 70B constituée ici du second ensemble 75 de couches élémentaires et de la couche de contact 76.

La première gravure utilise l'une des techniques de gravure listées en référence à la figure 5, étape 502. Elle utilise un premier masque 7020, pour protéger les zones à ne pas graver.

### Etape 703 :

Encapsulation latérale du premier empilement 700A, comme décrit en référence à la figure 6, étape 603, ou en référence à la figure 5, étape 503.

A l'issue de cette étape, on obtient, sur le premier substrat 710, une structure plane dite renversée 70' dans laquelle une face du premier empilement 700A affleure à la surface de la couche d'encapsulation latérale 77, du côté opposé au premier substrat 710'.

### Etape 704 :

Report, sur un second substrat 710, de l'ensemble formé par le premier substrat 710' et la structure renversée 70', et retrait du premier substrat 710'. Lors du report, l'ensemble formé par le premier substrat 710' et la structure renversée 70' est retourné, de sorte que le premier substrat 710' se trouve du côté opposé au second substrat 710.

Le second substrat 710 correspond ici au substrat décrit en référence à la figure 2, nommé également substrat hôte, sur lequel reposera la diode *in fine.*

### Etape 705 :

Seconde gravure, au cours de laquelle on grave la structure renversée 70' retournée sur le second substrat 710, sur une partie seulement de son épaisseur. Cette seconde gravure est mise en oeuvre après retrait du premier substrat 710'. Ici, on grave la seconde série de couches 70B constituée de la couche de contact 76 et du second ensemble 75 de couches élémentaires. La seconde gravure est arrêtée à l'interface avec la couche d'encapsulation latérale 77. Elle réalise, dans la seconde série de couches 70B, un second empilement 700B. Elle met en oeuvre des techniques telles que décrites en référence à l'étape 505 de la figure 5 ou l'étape 606 de la figure 6.

Comme détaillé en référence à la figure 5, une étape de gravure de tranchées dans la couche d'encapsulation latérale 77 est mise en oeuvre conjointement ou postérieurement à la seconde gravure.

On réalise ensuite des électrodes supérieure et inférieure, comme détaillé ci-dessus.

L'étape de report est mise en oeuvre avant la deuxième gravure et avant la réalisation des électrodes, de sorte qu'elle n'implique que des structures entièrement planes et ne nécessite pas d'alignement particulier. Après le report, aucune couche sacrificielle ne s'étend entre le second substrat 710 et la structure renversée 70'. Les diodes laser sont destinées à rester sur le second substrat 170. En particulier, elles ne sont pas reportées sur un troisième substrat, par un procédé de type « pick and place ».

L'invention n'est pas limitée aux exemples de procédé et de dispositifs décrits ci-dessus. Par exemple :
- la zone de tampon peut être dopée N et la zone de contact dopée P, ou inversement ;
- le substrat de la diode laser peut être un substrat dit III-V (composé d'un ou plusieurs éléments de la colonne III et de la colonne V du tableau périodique de Mendeleïev), ou un substrat en silicium (couche de silicium isolée, ou couche de silicium appartenant à un empilement de type silicium sur isolant, etc.), ou tout autre substrat adapté. Le silicium utilisé pourra être traité afin de lui donner les fonctions électriques usuelles de la micro-électronique de type CMO. ;
- les miroirs de Bragg inférieur et supérieur ainsi que la zone à puit(s) quantique(s) peuvent être formés en matériau à base de GaN (nitrure de gallium) (VCSEL GaN), ou tout autre matériau semi-conducteur adapté. Les matériaux à base de GaAs et AlGaAs sont cependant préférés.

De préférence, on réalise conjointement une pluralité de diodes laser sur un même substrat, ou wafer. La gravure de tranchées pour délimiter la région périphérique de chaque diode peut permettre d'isoler les diodes les unes des autres.

L'invention couvre également un dispositif émetteur de lumière dit « RC-LED » (pour « *Resonant Cavity- Light Emitting Diode* »), qui diffère d'une diode laser de type VCSEL en ce qu'il est dépourvu du miroir de Bragg supérieur. Dans ce cas, le second empilement tel que décrit dans le texte est dépourvu de miroir de Bragg supérieur. Il comprend de préférence une zone de contact dopée N ou P, telle que décrite dans le texte. Avantageusement, il comprend également une zone active d'émission de photons, telle que la zone à multi-puits quantiques décrite dans le texte.

L'invention trouve à s'appliquer notamment dans le domaine des télécommunications par fibres optiques, et dans le domaine de la télédétection (imagerie en trois dimensions, système LIDAR monté sur véhicule automobile, etc.).

## Revendications

1. Diode laser (200; 300; 400) comportant, superposés au-dessus d'un substrat (210 ; 510 ; 610 ; 710), le long d'un axe orthogonal au plan dudit substrat :
- un miroir de Bragg inférieur (230 ; 330 ; 530 ; 730),
- une zone à puit(s) quantique(s) (240 ; 340 ; 540 ; 740), et
- un miroir de Bragg supérieur (250; 350 ; 550), avec le miroir de Bragg inférieur (230; 330 ; 530; 730) situé entre le substrat et la zone à puit(s) quantique(s), **caractérisée en ce que** :
- une section (*S_{A}*) du miroir de Bragg inférieur présente une aire inférieure à celle d'une section (*S_{B}*) du miroir de Bragg supérieur, lesdites sections étant définies dans des plans parallèles au plan du substrat ;
- la diode laser (200; 300; 400) comprend une région dite périphérique (270), constituée d'un matériau dit de confinement, située entre le substrat et le miroir de Bragg supérieur, et entourant le miroir de Bragg inférieur (230; 330; 530; 730) ;
- les parois latérales du miroir de Bragg inférieur se trouvent en contact physique direct avec un matériau empêchant une fuite latérale des porteurs de charge, ledit matériau réalisant une couche d'encapsulation latérale (57) constituée d'un semi-conducteur non dopé, notamment d'un matériau III-V d'accord de maille compatible avec le substrat (510) ; et
- ladite diode laser (200; 300; 400) est dépourvue de toute couche oxydée latéralement.

2. Diode laser (200; 300; 400) selon la revendication 1, **caractérisée en ce qu'**elle comprend au moins une électrode supérieure (280B), qui s'étend en totalité ou en partie sur des parois latérales du miroir de Bragg supérieur (250 ; 350 ; 550).

3. Diode laser (200 ; 300 ; 400) selon la revendication 2, **caractérisée en ce que** les parois latérales du miroir de Bragg inférieur (230; 330; 530; 730) sont en contact physique direct avec au moins un matériau électriquement isolant ou semi-conducteur non-dopé.

4. Diode laser (200 ; 300; 400) selon l'une quelconque des revendications 1 à 3, **caractérisée en ce qu'**elle est constituée de matériaux à base d'arséniure de gallium.

5. Procédé de fabrication d'une diode laser (200; 300; 400) selon l'une quelconque des revendications 1 à 4, **caractérisé en ce qu'**il comprend :
- une première étape de gravure (502; 602 ; 702), dans laquelle on grave une première série de couches (50A; 60A; 70A) comprenant, au moins, un premier ensemble (53 ; 73) de couches élémentaires optiquement réfléchissant, de manière à former un premier empilement (200A; 300A; 500A; 600A; 700A) comprenant au moins le miroir de Bragg inférieur ;
- une seconde étape de gravure (505; 606; 705), dans laquelle on grave une seconde série de couches (50B ; 60B ; 70B) comprenant, au moins, un second ensemble (55 ; 75) de couches élémentaires optiquement réfléchissant, de manière à former un second empilement (200B ; 300B ; 400B ; 500B ; 600B ; 700B) comprenant au moins le miroir de Bragg supérieur; et
- une étape (503; 603 ; 703) d'encapsulation latérale du premier empilement (200A ; 300A ; 600A ; 700A), mise en oeuvre après la première étape de gravure ;
une section (*S_{A}*) du premier empilement présentant une aire inférieure à celle d'une section (*S_{B}*) du second empilement, et la deuxième étape de gravure (505 ; 606 ; 705) étant mise en oeuvre après la première étape de gravure (502 ; 602 ; 702).

6. Procédé selon la revendication 5, **caractérisé en ce qu'**il comprend les étapes suivantes :
- une première épitaxie (601), sur un premier substrat (610), pour former la première série de couches (60A) ;
- la première étape de gravure (602), pour former le premier empilement (600A) comprenant le miroir de Bragg inférieur au moins ;
- l'étape d'encapsulation latérale (603), à l'issue de laquelle on obtient une première structure (60A'), plane, sur le premier substrat (610) ;
- une seconde épitaxie (604), sur un second substrat (610') distinct du premier substrat, pour former la seconde série de couches (60B), la seconde série de couches (60B) et le second substrat formant ensemble une seconde structure (60B') ;
- un report (605) de la seconde structure (60B') sur la première structure (60A'), suivi d'un retrait du second substrat (610') ; et
- la deuxième étape de gravure (606), mise en oeuvre après l'étape de report (605), pour former le second empilement (600B) comprenant le miroir de Bragg supérieur au moins.

7. Procédé selon la revendication 6, **caractérisé en ce que** la première épitaxie (601) et la seconde épitaxie (604) sont mises en oeuvre au moins en partie simultanément.

8. Procédé selon la revendication 5, **caractérisé en ce qu'**il comprend les étapes suivantes :
- une première épitaxie (501), sur un premier substrat (510), pour former la première série de couches (50A) ;
- la première étape de gravure (502), pour former le premier empilement (500A) comprenant le miroir de Bragg inférieur au moins ;
- l'étape d'encapsulation latérale (503), à l'issue de laquelle on obtient une première structure (50A'), plane, sur le premier substrat (510) ;
- une nouvelle épitaxie (504), sur la première structure (50A'), pour former la seconde série de couches (50B) ; et
- la deuxième étape de gravure (505), mise en oeuvre après la nouvelle épitaxie (504), pour former le second empilement (500B) comprenant le miroir de Bragg supérieur au moins.

9. Procédé selon la revendication 5, **caractérisé en ce qu'**il comprend les étapes suivantes :
- une épitaxie (701), sur un premier substrat (710'), pour former une série de couches comprenant la seconde série de couches (70B) et la première série de couches(70A) ;
- la première étape de gravure (702), pour former le premier empilement (700A) comprenant le miroir de Bragg inférieur au moins ;
- l'étape d'encapsulation latérale (703), à l'issue de laquelle on obtient, sur le premier substrat (710'), une structure plane dite renversée (70') ;
- un report (703), sur un second substrat (710), de l'ensemble formé par le premier substrat et la structure renversée, suivi d'un retrait du premier substrat (710') ; et
- la deuxième étape de gravure (705), mise en oeuvre après l'étape de report (703), pour former le second empilement (700B) comprenant le miroir de Bragg supérieur au moins.

10. Procédé selon l'une quelconque des revendications 5 à 9, **caractérisé en ce que** l'étape (603 ; 703) d'encapsulation latérale du premier empilement (200A ; 300A ; 600A ; 700A) comprend des sous-étapes de dépôt d'une couche d'encapsulation (671) et planarisation.

11. Procédé selon l'une quelconque des revendications 5 à 9, **caractérisé en ce que** l'étape (503 ; 703) d'encapsulation latérale du premier empilement (200A ; 300A ; 500A ; 700A) comprend une étape de croissance de matériau.

12. Procédé selon l'une quelconque des revendications 5 à 11, **caractérisé en ce qu'**il comprend une étape de réalisation d'une électrode supérieure, mise en oeuvre après la deuxième étape de gravure (505 ; 606 ; 705), et de sorte que ladite électrode supérieure s'étende en totalité ou en partie sur des parois latérales du premier empilement (200A ; 300A ; 500A ; 600A ; 700A).

## Patentansprüche

1. Laserdiode (200; 300; 400), überlagert über einem Substrat (210; 510; 610; 710), entlang einer Achse orthogonal zur Ebene des Substrats, beinhaltend:
- einen unteren Bragg-Spiegel (230; 330; 530; 730),
- eine Zone von Quantentopf(töpfen) (240; 340; 540; 740), und
- einen oberen Bragg-Spiegel (250; 350; 550),
wobei sich der untere Bragg-Spiegel (230; 330; 530; 730), zwischen dem Substrat und der Zone von Quantentopf(töpfen) befindet, **dadurch gekennzeichnet, dass**:
- ein Abschnitt (*S_{A}*) des unteren Bragg-Spiegels eine kleinere Fläche aufweist als die eines Abschnitts (*S_{B}*) des oberen Bragg-Spiegels, wobei die Abschnitte in Ebenen parallel zur Substratebene definiert sind;
- die Laserdiode (200; 300; 400) einen peripheren Bereich (270) umfasst, der aus einem Begrenzungsmaterial besteht, das sich zwischen dem Substrat und dem oberen Bragg-Spiegel befindet, und den unteren Bragg-Spiegel (230; 330; 530; 730) umgibt;
- die Seitenwände des unteren Bragg-Spiegels in direktem physischen Kontakt mit einem Material stehen, das ein seitliches Austreten der Ladungsträger verhindert, wobei das Material eine seitliche Verkapselungsschicht (57) erstellt, die aus einem nicht-dotierten Halbleiter besteht, insbesondere aus einem III-V-Material mit einer Gitterkonstante, die mit dem Substrat (510) kompatibel ist; und
- die Laserdiode (200; 300; 400) seitlich frei von jeglicher oxidierten Schicht ist.

2. Laserdiode (200; 300; 400) nach Anspruch 1, **dadurch gekennzeichnet, dass** sie mindestens eine obere Elektrode (280B) umfasst, die sich ganz oder teilweise über die Seitenwände des oberen Bragg-Spiegels (250; 350; 550) erstreckt.

3. Laserdiode (200; 300; 400) nach Anspruch 2, **dadurch gekennzeichnet, dass** die Seitenwände des unteren Bragg-Spiegels (230; 330; 530; 730) in direktem physischen Kontakt mit mindestens einem elektrisch isolierenden Material oder einem nicht-dotierten Halbleiter stehen.

4. Laserdiode (200; 300; 400) nach einem der Ansprüche 1 bis 3, **dadurch gekennzeichnet, dass** sie aus Materialien auf Galliumarsenidbasis besteht.

5. Verfahren zur Herstellung einer Laserdiode (200; 300; 400) nach einem der Ansprüche 1 bis 4, **dadurch gekennzeichnet, dass** es umfasst:
- einen ersten Ätzschritt (502; 602; 702), wobei eine erste Reihe von Schichten (50A; 60A; 70A) geätzt wird, die mindestens eine erste Anordnung (53; 73) von optisch reflektierenden Elementarschichten umfassen, um einen ersten Stapel (200A; 300A; 500A; 600A; 700A) zu bilden, der mindestens den unteren Bragg-Spiegel umfasst;
- einen zweiten Ätzschritt (505; 606; 705), bei dem eine zweite Reihe von Schichten (50B; 60B; 70B) geätzt wird, die mindestens eine zweite Anordnung (55; 75) von optisch reflektierenden Elementarschichten umfassen, um einen zweiten Stapel (200B; 300B; 400B; 500B; 600B; 700B) zu bilden, der mindestens den oberen Bragg-Spiegel umfasst; und
- einen Schritt (503; 603; 703) der seitlichen Verkapselung des ersten Stapels (200A; 300A; 600A; 700A), durchgeführt nach dem ersten Ätzschritt;
wobei ein Abschnitt (*S_{A}*) des ersten Stapels eine Fläche aufweist, die kleiner ist als die eines Abschnitts (*S_{B}*) des zweiten Stapels, und der zweite Ätzschritt (505; 606; 705) nach dem ersten Ätzschritt (502; 602; 702) durchgeführt wird.

6. Verfahren nach Anspruch 5, **dadurch gekennzeichnet, dass** es die folgenden Schritte umfasst:
- eine erste Epitaxie (601) auf einem ersten Substrat, (610), um die erste Reihe von Schichten (60A) zu bilden;
- den ersten Ätzschritt (602), um den ersten Stapel (600A) zu bilden, der mindestens den unteren Bragg-Spiegel umfasst;
- den seitlichen Verkapselungsschritt (603), nach dessen Abschluss eine erste ebene Struktur (60A') auf dem ersten Substrat (610) erhalten wird;
- eine zweite Epitaxie (604) auf einem zweiten Substrat (610'), das sich vom ersten Substrat unterscheidet, um die zweite Reihe (60B) von Schichten zu bilden, wobei die zweite Reihe (60B) von Schichten und das zweite Substrat zusammen eine zweite Struktur (60B') bilden;
- eine Übertragung (605) der zweiten Struktur (60B') auf die erste Struktur (60A'), gefolgt von einer Entfernung des zweiten Substrats (610'); und
- den zweiten Ätzschritt (606), der nach dem Übertragungsschritt (605) durchgeführt wird, um den zweiten Stapel (600B) zu bilden, der mindestens den oberen Bragg-Spiegel umfasst.

7. Verfahren nach Anspruch 6, **dadurch gekennzeichnet, dass** die erste Epitaxie (601) und die zweite Epitaxie (604) mindestens teilweise gleichzeitig durchgeführt werden.

8. Verfahren nach Anspruch 5, **dadurch gekennzeichnet, dass** es die folgenden Schritte umfasst:
- eine erste Epitaxie (501) auf einem ersten Substrat (510), um die erste Reihe von Schichten (50A) zu bilden;
- den ersten Ätzschritt (502), um den ersten Stapel (500A) zu bilden, der mindestens den unteren Bragg-Spiegel umfasst;
- den seitlichen Verkapselungsschritt (503), nach dessen Abschluss eine erste ebene Struktur (50A') auf dem ersten Substrat (510) erhalten wird;
- eine neue Epitaxie (504) auf der ersten Struktur (50A'), um die zweite Reihe (50B) von Schichten zu bilden; und
- den zweiten Ätzschritt (505), der nach der neuen Epitaxie (504) durchgeführt wird, um den zweiten Stapel (500B) zu bilden, der mindestens den oberen Bragg-Spiegel umfasst.

9. Verfahren nach Anspruch 5, **dadurch gekennzeichnet, dass** es die folgenden Schritte umfasst:
- eine Epitaxie (701) auf einem ersten Substrat (710'), um eine Reihe von Schichten zu bilden, die die zweite Reihe (70B) von Schichten und die erste Reihe von Schichten (70A) umfasst;
- den ersten Ätzschritt (702), um den ersten Stapel (700A) zu bilden, der mindestens den unteren Bragg-Spiegel umfasst;
- den seitlichen Verkapselungsschritt (703), nach dessen Abschluss auf dem ersten Substrat (710') eine umgedrehte ebene Struktur (70') erhalten wird;
- eine Übertragung (703), auf einem zweiten Substrat (710), der Anordnung, die durch das erste Substrat und die umgedrehte Struktur gebildet wird, gefolgt von einer Entfernung des ersten Substrats (710'); und
- den zweiten Ätzschritt (705), der nach dem Übertragungsschritt (703) durchgeführt wird, um den zweiten Stapel (700B) zu bilden, der mindestens den oberen Bragg-Spiegel umfasst.

10. Verfahren nach einem der Ansprüche 5 bis 9, **dadurch gekennzeichnet, dass** der Schritt (603; 703) der seitliche Verkapselung des ersten Stapels (200A; 300A; 600A; 700A) Teilschritte zum Abscheiden einer Schicht der Verkapselung (671) und Planarisierung umfasst.

11. Verfahren nach einem der Ansprüche 5 bis 9, **dadurch gekennzeichnet, dass** der Schritt (503; 703) der seitlichen Verkapselung des ersten Stapels (200A; 300A; 500A; 700A) einen Schritt des Materialwachstums umfasst.

12. Verfahren nach einem der Ansprüche 5 bis 11, **dadurch gekennzeichnet, dass** es einen Schritt zum Erstellen einer oberen Elektrode umfasst, der nach dem zweiten Ätzschritt (505; 606; 705) durchgeführt wird, und so, dass sich die obere Elektrode ganz oderteilweise über die Seitenwände des ersten Stapels (200A; 300A; 500A; 600A; 700A) erstreckt.

## Claims

1. Laser diode (200; 300; 400) comprising, superimposed on top of a substrate (210; 510; 610; 710), along an axis orthogonal to the plane of said substrate:
- a bottom Bragg mirror (230; 330; 530; 730),
- a region of one or more quantum wells (240; 340; 540; 740), and
- a top Bragg mirror (250; 350; 550),
wherein the bottom Bragg mirror (230; 330; 530; 730) is situated between the substrate and the region of one or more quantum wells, **characterised in that**:
- a section (*S_{A}*) of the bottom Bragg mirror has an area that is less than that of a section (*S_{B}*) of the top Bragg mirror, said sections being defined in planes parallel to the plane of the substrate; and
- the laser diode (200; 300; 400) comprises a so-called peripheral region (270), constituted by a so-called confinement material, situated between the substrate and the top Bragg mirror, and surrounding the bottom Bragg mirror (230; 330; 530; 730);
- the side walls of the bottom Bragg are in direct physical contact with a material preventing a material preventing lateral leakage of charge carriers, said material forming a lateral encapsulating layer (57) constituted from an undoped semiconductor, in particular a lattice-matched group III-V material compatible with the substrate (510); and
- said laser diode (200; 300; 400) is devoid of any laterally-oxidised layer.

2. Laser diode (200; 300; 400) according to claim 1, **characterised in that** it comprises at least one top electrode (280B), which extends in full or in part over side walls of the top Bragg mirror (250; 350; 550).

3. Laser diode (200; 300; 400) according to claim 2, **characterised in that** the side walls of the bottom Bragg mirror (230; 330; 530; 730) are in direct physical contact with at least one undoped semiconductor or electrically insulating material.

4. Laser diode (200; 300; 400) according to any of claims 1 to 3, **characterised in that** it is constituted by gallium arsenide-based materials.

5. Method for manufacturing a laser diode (200; 300; 400) according to any of claims 1 to 4, **characterised in that** it comprises:
- a first etching step (502; 602; 702), in which a first series of layers (50A; 60A; 70A) is etched, said first series of layers at least comprising a first set (53; 73) of optically-reflective basic layers so as to form a first stack (200A; 300A; 500A; 600A; 700A) comprising at least the bottom Bragg mirror;
- a second etching step (505; 606; 705), in which a second series of layers (50B; 60B; 70B) is etched, said second series of layers at least comprising a second set (55; 75) of optically-reflective basic layers so as to form a second stack (200B; 300B; 400B; 500B; 600B; 700B) comprising at least the top Bragg mirror; and
- a step (503; 603; 703) of laterally encapsulating the first stack (200A; 300A; 600A; 700A), implemented after the first etching step;
wherein a section (*S_{A}*) of the first stack has an area that is less than that of a section (*S_{B}*) of the second stack, and wherein the second etching step (505; 606; 705) is implemented after the first etching step (502; 602; 702).

6. Method according to claim 5, **characterised in that** it comprises the steps of:
- a first epitaxy (601) on a first substrate (610) in order to form the first series of layers (60A);
- the first etching step (602) in order to form the first stack (600A) comprising at least the bottom Bragg mirror;
- the lateral encapsulation step (603) at the end whereof a first planar structure (60A') is obtained on the first substrate (610);
- a second epitaxy (604) on a second substrate (610') that is separate from the first substrate, in order to form the second series of layers (60B), the second series of layers (60B) and the second substrate jointly forming a second structure (60B');
- a placement (605) of the second structure (60B') on the first structure (60A'), followed by a removal of the second substrate (610'); and
- the second etching step (606), implemented after the placement step (605), in order to form the second stack (600B) comprising at least the top Bragg mirror.

7. Method according to claim 6, **characterised in that** the first epitaxy (601) and the second epitaxy (604) are at least partially implemented simultaneously.

8. Method according to claim 5, **characterised in that** it comprises the steps of:
- a first epitaxy (501) on a first substrate (510) in order to form the first series of layers (50A);
- the first etching step (502) in order to form the first stack (500A) comprising at least the bottom Bragg mirror;
- the lateral encapsulation step (503) at the end whereof a first planar structure (50A') is obtained on the first substrate (510);
- a new epitaxy (504) on the first structure (50A') in order to form the second series of layers (50B); and
- the second etching step (505), implemented after the new epitaxy (504), in order to form the second stack (500B) comprising at least the top Bragg mirror.

9. Method according to claim 5, **characterised in that** it comprises the steps of:
- an epitaxy (701) on a first substrate (710') in order to form a series of layers comprising the second series of layers (70B) and the first series of layers (70A);
- the first etching step (702) in order to form the first stack (700A) comprising at least the bottom Bragg mirror;
- the lateral encapsulation step (703) at the end whereof a so-called upside-down planar structure (70') is obtained on the first substrate (710');
- a placement (703), on a second substrate (710), of the assembly formed by the first substrate and the upside-down structure, followed by a removal of the first substrate (710'); and
- the second etching step (705), implemented after the placement step (703), in order to form the second stack (700B) comprising at least the top Bragg mirror.

10. Method according to any of claims 5 to 9, **characterised in that** the step (603; 703) of laterally encapsulating the first stack (200A; 300A; 600A; 700A) comprises sub-steps of depositing an encapsulating layer (671) and planarisation.

11. Method according to any of claims 5 to 9, **characterised in that** the step (503; 703) of laterally encapsulating the first stack (200A; 300A; 500A; 700A) comprises a step of material growth.

12. Method according to any of claims 5 to 11, **characterised in that** it comprises a step of producing a top electrode, carried out after the second etching step (505; 606; 705), and such that said top electrode extends in full or in part over side walls of the first stack (200A; 300A; 500A; 600A; 700A).
